# EUROPÄISCHE PATENTANMELDUNG

(11) **EP 3 736 923 A1**
(43) Veröffentlichungstag der Anmeldung: **11.11.2020**
(21) Anmeldenummer: 20173218.7
(22) Anmeldetag: 06.05.2020
(51) Int. Cl.: H01S 5/022, H01S 5/183, G01S 7/00, H01L 23/00

(54) **HALBLEITER-PACKAGE UND LIDAR-SENDEEINHEIT**

(30) Priorität: 07.05.2019 DE 102019206508
(71) Anmelder: Ibeo Automotive Systems GmbH, 22143 Hamburg (DE)
(72) Erfinder: Hakspiel, Stefan, 88074 Meckenbeuren (DE)
(74) Vertreter: RGTH

(57) **Zusammenfassung**

Die vorliegende Erfindung bezieht sich auf ein Halbleiter-Package sowie auf eine LIDAR-Sendeeinheit mit einem solchen Halbleiter-Package. Das Halbleiter-Package umfasst einen oberflächenemittierenden Laser, zumindest eine Treiberschaltung für den oberflächenemittierenden Laser, eine Verbindungsstruktur und zumindest einen Interposer. Die Verbindungsstruktur umfasst eine Mehrzahl von Löthöckern. Der oberflächenemittierende Laser ist über den zumindest einen Interposer und die Verbindungsstruktur mit der zumindest einen Treiberschaltung elektrisch verschaltet.

## Beschreibung

Die vorliegende Erfindung bezieht sich auf ein Halbleiter-Package, genauer auf ein Halbleiter-Package mit einem oberflächenemittierenden Laser, zumindest einer Treiberschaltung für den oberflächenemittierenden Laser und zumindest einem Interposer, sowie auf eine LIDAR-Sendeeinheit mit einem solchen Halbleiter-Package.

In Laser-Array-Anordnungen, etwa für LIDAR-Anwendungen (Light Detection and Ranging, Lichtbasierte Detektion und Entfernungsmessung), werden häufig oberflächenemittierende Laser, sog. VCSEL (Vertical-Cavity Surface-Emitting Laser, Oberflächenemittierender Laser mit vertikalem Resonator) genutzt. Diese oberflächenemittierenden Laser werden, zusammen mit entsprechenden Treiberschaltungen, an einem Halbleiter-Package angeordnet. Dabei ist es üblich, dass die elektrische Kontaktierung zwischen den Treiberschaltungen und dem oberflächenemittierenden Laser mittels Bonddrähten geschieht.

Solche Bonddrähte haben in manchen Anwendungen, wie etwa im automobilen Umfeld, einen Abstand (auch engl. "Pitch"), der durch einen Mindestabstand limitiert ist, um Berührungen, die zu Kurzschlüssel führen können, aufzuschließen. Dadurch haben die Zeilen der Laserdioden im oberflächenemittierenden Laser einen Mindestabstand, der auf dem Mindestabstand der Bonddrähte beruht. Bei einer zumindest geforderten Auflösung des oberflächenemittierenden Lasers ist so eine Mindestgröße des Lasers vorgegeben, was zu hohen Kosten in der Halbleiterfertigung führen kann, da sowohl die Halbleiterfläche an sich als auch die Fehlerrate, die bei größeren Halbleiterbauelementen den Ausschuss erhöht, zu höheren Kosten führt.

Es stellt sich daher die erfindungsgemäße Aufgabe, ein kostengünstigeres Laser-Array bereitzustellen, das im automobilen Umfeld, etwa in LIDAR-Anwendungen, nutzbar ist.

Diese Aufgabe wird durch das Halbleiter-Package gemäß Anspruch 1 sowie durch die LIDAR-Sendeeinheit gemäß Anspruch 15 gelöst.

Die Erfindung basiert auf der Idee, an Stelle der Kontaktierung durch Bonddrähte eine Kontaktierung über einen sog. Interposer (wörtlich "Zwischensetzer") zu nutzen, wobei der Interposer über sog. Löthöcker (engl. "Bumps") mit dem oberflächenemittierenden Laser und den entsprechenden Treiberschaltungen kontaktiert ist. Da solche Interposer ebenfalls in einem Halbleiter-Fertigungsverfahren hergestellt werden können, können diese einen sehr geringen Pitch der Kontaktierungen aufweisen, was die Nutzung von oberflächenemittierenden Lasern mit einem engen Zeilenabstand ermöglicht. Dadurch kann, bei gleichbleibender Auflösung des oberflächenemittierenden Lasers, dieser verkleinert werden, so dass kostengünstige Laser-Arrays ermöglicht werden.

Ausführungsbeispiele schaffen somit ein Halbleiter-Package mit einem oberflächenemittierenden Laser, zumindest einer Treiberschaltung für den oberflächenemittierenden Laser, einer Verbindungsstruktur und zumindest einem Interposer. Die Verbindungsstruktur umfasst eine Mehrzahl von Löthöckern. Der oberflächenemittierende Laser ist über den zumindest einen Interposer und die Verbindungsstruktur mit der zumindest einen Treiberschaltung elektrisch verschaltet. Ein solches Halbleiter-Package löst, wie bereits oben dargelegt, die erfindungsgemäße Aufgabe.

In manchen Varianten umfasst das Halbleiter-Package ferner eine Vergussstruktur (auch engl. "Potting") Diese Vergussstruktur kann dazu ausgelegt sein, um die Verbindungsstruktur gegenüber Außeneinwirkungen abzuschirmen. Dies ermöglicht eine größere Robustheit des Halbleiter-Packages, gerade im rauen Automobil-Umfeld.

Dabei kann die Vergussstruktur zumindest teilweise zwischen dem oberflächenemittierenden Laser und einem Package-Substrat des Halbleiter-Package angeordnet sein. So kann die Vergussstruktur Teil des sog. Underfill (Unterfüllung) des Halbleiter-Packages sein.

Trotzdem kann ein Teil des oberflächenemittierenden Lasers in direktem Kontakt mit dem Package-Substrat stehen. Dies ermöglicht eine stabile Befestigung des oberflächenemittierenden Lasers an dem Package-Substrat.

Der zumindest eine Interposer kann beispielsweise zumindest teilweise vertikal zwischen dem oberflächenemittierenden Laser und dem Package-Substrat angeordnet sein. Alternativ kann der zumindest eine Interposer durch das Package-Substrat gebildet werden. Dies ermöglicht eine flache Konstruktion.

Alternativ kann der zumindest eine oberflächenemittierende Laser zumindest teilweise vertikal zwischen dem zumindest einen Interposer und dem Package-Substrat angeordnet sein. Dies ermöglicht gegebenenfalls eines stabilere Befestigung des Oberflächenemittierenden Lasers und der zumindest einen Treiberschaltung an dem Package-Substrat.

In Ausführungsbeispielen entspricht die Mehrzahl von Löthöckern einer Mehrzahl von Mikro-Höckern. Dies ermöglicht einen besonders engen Pitch.

In zumindest einigen Ausführungsbeispielen umfasst das Halbleiter-Package eine weitere Verbindungsstruktur. Eine Anschlussstruktur des Package-Substrats kann über die weitere Verbindungsstruktur mit der zumindest einen Treiberschaltung elektrisch verschaltet sein. Dies ermöglicht die elektrische Kontaktierung der zumindest einen Treiberschaltung über das Package-Substrat.

Entsprechend kann das Halbleiter-Package auch eine weitere Vergussstruktur umfassen. Die weitere Vergussstruktur kann dazu ausgelegt sein, um die weitere Verbindungsstruktur gegenüber Außeneinwirkungen abzuschirmen. Dies ermöglicht eine größere Robustheit des Halbleiter-Packages, gerade im rauen Automobil-Umfeld.

Dabei kann die zumindest eine Treiberschaltung über verschiedene Kontaktierungstechnologien mit der Anschlussstruktur des Package-Substrats elektrisch verschaltet elektrisch verschaltet sein. So kann die zumindest eine Treiberschaltung jeweils über ein oder mehrere Bond-Drähte der weiteren Verbindungsstruktur mit der Anschlussstruktur des Package-Substrats elektrisch verschaltet sein. Alternativ oder zusätzlich kann die zumindest eine Treiberschaltung jeweils über ein oder mehrere Löthöcker der weiteren Verbindungsstruktur mit der Anschlussstruktur des Package-Substrats elektrisch verschaltet sein. Beide Kontaktierungstechnologien haben Vor- und Nachteile in Bezug auf Fertigung, Kosten und Robustheit.

Die zumindest eine Treiberschaltung kann beispielsweise jeweils über ein oder mehrere Löthöcker der weiteren Verbindungsstruktur über den zumindest einen Interposer mit der Anschlussstruktur des Package-Substrats elektrisch verschaltet sein. So kann der Interposer etwa als Träger dienen, auf dem die übrigen Komponenten angeordnet sind.

In zumindest manchen Ausführungsbeispielen ist der zumindest eine Interposer zumindest ein Halbleiter-Bauelement. Dies ermöglicht die Fertigung von besonders feinen Strukturen, und damit auch einen besonders kleinen Pitch.

Eine horizontale Fläche des zumindest einen Interposers kann eine horizontale Fläche des oberflächenemittierenden Lasers und der zumindest einen Treiberschaltung zumindest teilweise seitlich überragen. Dies ermöglicht eine Kontaktierung des Interposers über Bonddrähte, etwa um den Interposer mit dem Package-Substrat elektrisch zu kontaktieren.

Ausführungsbeispiele schaffen so einen robusten und / oder miniaturisierter Aufbau von Elektronikkomponenten für Laser-Array & Lidar Anwendungen. Dabei kann, durch Verwendung neuer mikroelektronischer Aufbau- und Verbindungstechniken, wie etwa der Nutzung von Bumps, eine weitere Miniaturisierung der Laserdioden-Abstände erreicht werden. Da die Spezialhalbleitermaterialien extrem teuer sind, können hierdurch Chipfläche und somit Kosten eingespart werden. Außerdem ist eine solche Verbindung robuster als durch Bonddrähte.

Weitere vorteilhafte Ausgestaltungen werden nachfolgend anhand der in den Zeichnungen dargestellten Ausführungsbeispiele, auf welche Ausführungsbeispiele generell jedoch nicht insgesamt beschränkt sind, näher beschrieben. Es zeigen:
- Fig. 1: zeigt ein Ausführungsbeispiel eines Halbleiter-Package;
- Fig. 2: zeigt ein weiteres Ausführungsbeispiel eines Halbleiter-Package, das zumindest eine Vergussstruktur umfasst;
- Fig. 3: zeigt ein weiteres Ausführungsbeispiel eines Halbleiter-Package, bei dem zwei Interposer zwischen dem Package-Substrat und dem oberflächenemittierenden Laser angeordnet sind;
- Fig. 4: zeigt ein weiteres Ausführungsbeispiel eines Halbleiter-Package, bei dem ein Teil des oberflächenemittierenden Lasers in direktem Kontakt mit dem Package-Substrat steht; und
- Fig. 5: zeigt ein weiteres Ausführungsbeispiel eines Halbleiter-Package, bei dem der oberflächenemittierende Laser und zwei Treiberschaltungen auf dem Interposer angeordnet sind.

Verschiedene Ausführungsbeispiele werden nun ausführlicher unter Bezugnahme auf die beiliegenden Zeichnungen beschrieben, in denen einige Ausführungsbeispiele dargestellt sind. Bei der nachfolgenden Beschreibung der beigefügten Figuren, die lediglich einige exemplarische Ausführungsbeispiele zeigen, können gleiche Bezugszeichen gleiche oder vergleichbare Komponenten bezeichnen. Ferner können zusammenfassende Bezugszeichen für Komponenten und Objekte verwendet werden, die mehrfach in einem Ausführungsbeispiel oder in einer Zeichnung auftreten, jedoch hinsichtlich eines oder mehrerer Merkmale gemeinsam beschrieben werden. Dabei ist eine vertikale Ausdehnung oder eine vertikale Anordnung orthogonal zu einer Vorderseite des Package-Substrats definiert, und eine laterale Ausdehnung oder eine laterale Anordnung ist parallel zu der Vorderseite des Package-Substrats definiert.

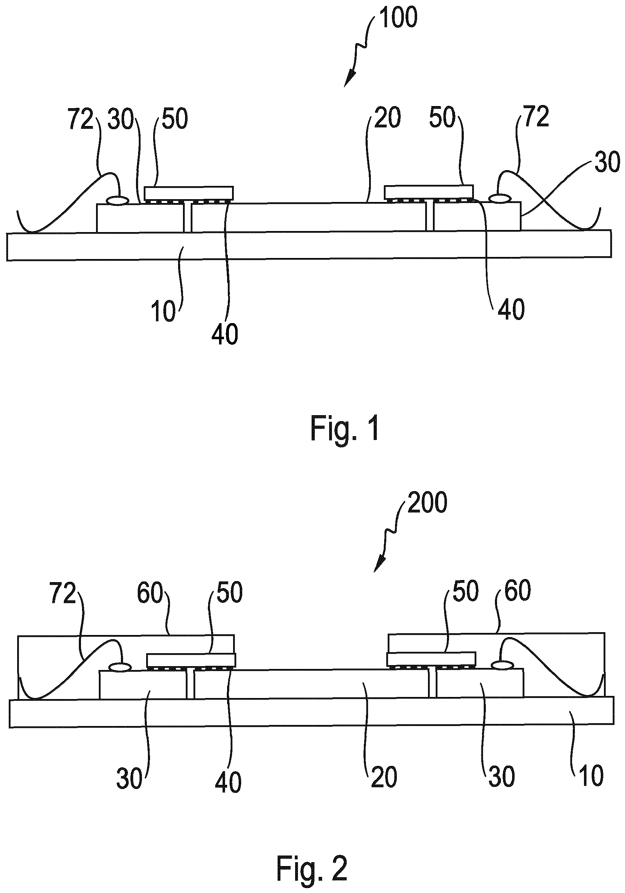

Fig. 1 zeigt ein Ausführungsbeispiel eines Halbleiter-Package. Das Halbleiter-Package 100 umfasst ein Package-Substrat 10, einen oberflächenemittierenden Laser 20, zwei Treiberschaltungen 30 für den oberflächenemittierenden Laser 20, eine Verbindungsstruktur 40 und zwei Interposer 50. Die Verbindungsstruktur umfasst eine Mehrzahl von Löthöckern. Der oberflächenemittierende Laser ist über den zumindest einen Interposer und die Verbindungsstruktur mit der zumindest einen Treiberschaltung elektrisch verschaltet.

Das Halbleiter-Package, das in Fig. 1 gezeigt ist, stellt ein Ausführungsbeispiel erfindungsgemäßer Halbleiter-Packages dar. Halbleiter-Package bedeutet dabei, dass das Halbleiter-Package dafür vorgesehen ist, zumindest einen Halbleiter-Chip, etwa den oberflächenemittierenden Laser und die zumindest eine Treiberschaltung, zu beherbergen und eine Kontaktierungsstruktur zum Anschließen des zumindest einen Halbleiter-Chips bereitzustellen. Dabei müssen die einzelnen Bestandteile des Halbleiter-Packages, insbesondere das Package-Substrat, nicht aus Halbleitermaterialen gefertigt sein. In Ausführungsbeispielen kann das Package-Substrat ein beliebiges Package-Substrat sein, etwa aus Leiterplattenmaterial. Dabei kann das Package-Substrat ein (organisches) Kunststoff-Substrat oder ein Keramik-Substrat sein. In manchen Ausführungsbeispielen verlaufen keine Leiterbahnen durch oder auf dem Package-Substrat. So kann das Package-Substrat etwa auch ein Aluminium-Package-Substrat sein.

Das Halbleiter-Package kann dabei ein Multi-Chip-Modul sein, also mehr als nur einen Chip beherbergen, etwa den oberflächenemittierenden Laser und die zumindest eine Treiberschaltung. Dabei sind in dem Halbleiter-Package von Fig. 1 zwei Treiberschaltungen 30 und der oberflächenemittierende Laser 20 direkt auf dem Package-Substrat angeordnet, bzw. sie stehen in direktem Kontakt mit dem Halbleiter-Substrat. In diesem Zusammenhang bedeutet "direkt angeordnet auf" oder "steht in direktem Kontakt", dass lediglich ein Befestigungsmittel, wie etwa eine Lötbefestigung oder ein Befestigungskleber zwischen dem Package-Substrat und dem jeweiligen Bauteil (Treiberschaltung, oberflächenemittierender Laser, oder später auch Interposer) angeordnet ist. Insbesondere ist eine Vergussstruktur, ein sog. Potting, nicht zwischen dem Package-Substrat und dem jeweiligen Bauteil angeordnet.

In dem Ausführungsbeispiel von Fig. 1 (wie auch in dem Ausführungsbeispiel von Fig. 2) ist jeder Interposer vertikal über dem oberflächenemittierenden Laser und einer der beiden Treiberschaltungen angeordnet. In anderen Worten ist der zumindest eine oberflächenemittierende Laser 20, wie auch die beiden Treiberschaltungen, zumindest teilweise vertikal zwischen dem Interposer 50 und dem Package-Substrat 10 angeordnet.

In den Ausführungsbeispielen der Figuren 1 bis 5 wird die Mehrzahl von Löthöckern durch Mikro-Höcker (sog. "Micro Bumps") gebildet. Mikro-Höcker stellen eine Spezialform von Löthöckern dar und sind dadurch definiert, dass sie kleiner sind als "normale" Löthöcker. Mikro-Höcker können dabei einen Durchmesser von weniger als 50 µm (oder weniger als 30 µm) aufweisen. Dabei sind auch Mikro-Höcker mit deutlich kleineren Durchmessern bekannt, bis hinunter auf 1 µm. Mikro-Höcker ermöglichen dabei einen besonders geringen Abstand zwischen benachbarten Löthöckern, und dadurch einen besonders geringen Zeilenabstand des oberflächenemittierenden Lasers. Dabei kann ein Abstand zwischen benachbarten Löthöckern der Mehrzahl von Löthöckern kleiner sein als 100 µm, etwa kleiner als 80 µm, oder kleiner als 50 µm Dabei impliziert benachbart, dass die beiden Löthöcker, deren Abstand gemessen wird an dem gleichen Bauteil (Laser oder Treiberschaltung) angeordnet sind. Als Alternative zu Mikro-Höckern können auch sog. Kupfer-Pfeiler genutzt werden (engl. "CU-Pillars"). Auch diese sind in der vorliegenden Anmeldung zu den Löthöckern zu zählen.

Um die Interposer und den oberflächenemittierenden Laser bzw. die beiden Treiberschaltungen elektrisch miteinander zu kontaktieren können sog. re-flow-Techniken eingesetzt werden, bei denen das Material der Höcker teilweise verflüssigt wird, bevor der Interposer auf den Laser und eine Treiberschaltung gesetzt wird (oder umgekehrt, wenn der oder die Interposer zwischen Package-Substrat und Laser/Treiberschaltung anordnet sind) und der Interposer mit den teilweise verflüssigten Höckern auf entsprechende Kontaktierungen des oberflächenemittierenden Lasers und einer Treiberschaltung abgesetzt wird. Dabei bilden die teilweise verflüssigten Höcker beim Erstarren eine selbst-ausrichtende Struktur, so dass der Interposer passgenau auf den Kontaktierungen des oberflächenemittierenden Lasers und der jeweiligen Treiberschaltung ausgerichtet ist. Das Verflüssigen kann dabei beispielsweise durch Heißluft bewirkt werden.

In zumindest einigen Ausführungsbeispielen ist der Interposer ein Halbleiter-Bauelement, d.h. der Interposer kann aus einem Halbleitermaterial, wie etwa Silizium, Siliziumkarbid oder Gallium-Arsenid gefertigt sein. In anderen Worten kann der Interposer aus oder auf einem Halbleiter-Wafer gefertigt sein. Alternativ kann der Interposer selbst ein Package-Substrat umfassen, das fein-granulare Leiterbahnen und Kontaktierungen ermöglicht, d.h. der Interposer kann durch ein weiteres Package-Substrat gebildet werden. Dabei kann der Interposer eine erste Mehrzahl von Kontaktierungen für die Kontaktierung des oberflächenemittierenden Lasers, eine zweite Mehrzahl von Kontaktierungen für die Kontaktierung einer Treiberschaltung, und eine Mehrzahl von Leiterbahnen umfassen, die eine elektrische Verbindung zwischen der ersten Mehrzahl von Kontaktierungen und der zweiten Mehrzahl von Kontaktierungen herstellen. Dabei können die erste Mehrzahl von Kontaktierungen und die zweite Mehrzahl von Kontaktierungen an der gleichen Seite des Interposers angeordnet sein.

In zumindest manchen Ausführungsbeispielen ist der oberflächenemittierende Laser ein VCSEL-Array, d.h. der oberflächenemittierende Laser umfasst eine Mehrzahl von Emitterelementen in einer ersten lateralen Ausdehnung des oberflächenemittierende Lasers, und eine Mehrzahl von Emitterelementen in einer zweiten, zu der ersten orthogonal angeordneten lateralen Ausdehnung des oberflächenemittierende Lasers. Beispielsweise kann der oberflächenemittierende Laser eine Mehrzahl von Emitterelementen umfassen, die in einer Matrix-Anordnung angeordnet sind. Alternativ kann eine andere Anordnung gewählt werden, etwa eine Anordnung, die auf Hexagonen basiert.

Dabei kann die Mehrzahl von Laser-Emittern zeilenweise angesteuert werden, d.h. jede Treiberschaltung kann eine Mehrzahl von Treiber-Zellen umfassen, wobei jede Zelle ausgebildet ist, um eine Zeile des oberflächenemittierenden Lasers anzusteuern. Jede Zeile des oberflächenemittierenden Lasers kann wiederum eine Mehrzahl von Emitterelementen umfassen. Dabei kann, wenn, so wie in den Fign. 1 bis 5, mehrere Treiber-Schaltungen verwendet werden, die Ansteuerung der Zeilen "Interleaved" ("verschachtelt") geschehen. Dies bedeutet, dass etwa bei zwei Treiberschaltungen die Zeilen des oberflächenemittierenden Lasers zeilenweise abwechselnd von den zwei Treiberschaltungen angesteuert werden. Dies ermöglicht wiederum einen geringeren Zeilenabstand.

Beispielsweise kann der oberflächenemittierende Laser ein oberflächenemittierender Laser für eine LIDAR-Sendeeinheit sein. Die LIDAR-Sendeeinheit kann dem Halbleiter-Package entsprechen, oder die LIDAR-Sendeeinheit kann das Halbleiter-Package umfassen. Der oberflächenemittierende Laser kann ausgebildet sein, um durch die Mehrzahl von Emitterelementen eine Mehrzahl von Laserstrahlen zu erzeugen, die dazu vorgesehen sind, über eine Sendeoptik ausgesandt zu werden. Dabei werden vorzugsweise Laserpulse verwendet.

Die zumindest eine Treiberschaltung ist ausgebildet, um zumindest einen Teil des oberflächenemittierenden Lasers anzusteuern. Dabei kann die zumindest eine Treiberschaltung ausgebildet sein, um basierend auf einem Steuersignal eine Mehrzahl von Stromversorgungssignalen zu generieren um die Mehrzahl von Emitterelementen anzusteuern. In anderen Worten kann jede Treiberschaltung ausgebildet sein, um die Stromversorgung von einer Mehrzahl von Emitterelementen des oberflächenemittierenden Lasers (basierend auf dem Steuersignal) zu steuern. Dabei kann jede Treiberschaltung ausgebildet sein, um das Steuersignal über eine weitere Verbindungsstruktur zu erhalten. Das Halbleiter-Package kann die weitere Verbindungsstruktur umfassen. Eine Anschlussstruktur des Package-Substrats 10 kann über die weitere Verbindungsstruktur mit der zumindest einen Treiberschaltung 30 elektrisch verschaltet sein. Das Steuersignal kann über die weitere Verbindungsstruktur übertragen werden. Dabei ist die weitere Verbindungsstruktur in den Fign. 1 und 2 als Bonddrähte 72 ausgebildet. In anderen Worten kann die zumindest eine Treiberschaltung 30 jeweils über ein oder mehrere Bond-Drähte 72 der weiteren Verbindungsstruktur mit der Anschlussstruktur des Package-Substrats 10 elektrisch verschaltet sein. Dabei kann die Anschlussstruktur des Package-Substrats beispielsweise eine erste Mehrzahl von Kontakten (Kontakt-Pads) zum Anschluss des Halbleiter-Packages an ein weiteres Bauteil und eine zweite Mehrzahl von Kontakten zum Verbinden der Treiberschaltung/Treiberschaltungen mit der Anschlussstruktur umfassen. Alternativ können die gleichen Kontakt-Pads zum Anschluss des Halbleiter-Packages an ein weiteres Bauteil und zum Verbinden der Treiberschaltung/Treiberschaltungen mit der Anschlussstruktur genutzt werden. In zumindest manchen Ausführungsbeispielen umfasst die Anschlussstruktur ferner eine Mehrzahl von Leiterbahnen, um die erste Mehrzahl von Kontakten mit der zweiten Mehrzahl von Kontakten elektrisch zu verschalten.

Wie bereits oben dargestellt kann das Halbleiter-Package Teil einer LIDAR-Sendeeinheit sein oder einer LIDAR-Sendeeinheit entsprechen. Eine LIDAR-Sendeeinheit ist zumeist ein Bestandteil eines LIDAR-Messsystems. Ausführungsbeispiele schaffen somit auch ein LIDAR-Messsystem umfassend eine LIDAR-Sendeeinheit mit dem Halbleiter-Package und eine LIDAR-Empfangseinheit. Das LIDAR Messsystem ist in seinem grundsätzlichen Aufbau gemäß den Ausführungen zum Stand der Technik (WO 2017/081294 A1) ausgebildet.

Die LIDAR Empfangseinheit und / oder die LIDAR Sendeeinheit sind günstiger Weise in einer Focal Plane-Array Konfiguration ausgebildet. Die Elemente der jeweiligen Einheit sind im Wesentlichen in einer Ebene, günstiger Weise auf einem Chip, angeordnet. Die jeweilige Einheit ist an dem LIDAR Messsystem vorzugsweise in einem Brennpunkt einer entsprechenden Optik, Sendeoptik, oder Empfangsoptik, angeordnet. Insbesondere sind die Sensorelemente bzw. die Emitterelemente im Brennpunkt der Empfangsoptik angeordnet. Eine solche Optik kann beispielsweise durch ein optisches Linsensystem ausgebildet sein.

Die LIDAR Empfangseinheit weist mehrere Sensorelemente auf, welche vorzugsweise als SPAD, Single Photon Avalanche Diode, ausgebildet sind. Die LIDAR Sendeeinheit weist mehrere Emitterelemente zur Aussendung von Laserlicht, günstigerweise Laserpulsen, auf. Die Emitterelemente sind günstiger Weise als VCSEL, Vertical Cavity surface emitting laser, ausgebildet.

Die Sendeeinheit weist Emitterelemente auf, die über eine Fläche des Sendechips, des oberflächenemittierenden Lasers, verteilt sind. Die Empfangseinheit weist Sensorelemente auf, die über eine Fläche des Empfangschips verteilt sind. Dem Sendechip ist eine Sendeoptik zugewiesen und dem Empfangschip ist eine Empfangsoptik zugewiesen. Die Optik bildet ein aus einem Raumbereich eintreffendes Licht auf den jeweiligen Chip ab. Der Raumbereich entspricht dem Sichtbereich des Messsystem, der auf Objekte untersucht oder sensiert wird.

Der Raumbereich der Sendeeinheit und der Empfangseinheit sind im Wesentlichen identisch. Die Sendeoptik bildet ein Emitterelement auf einen Raumwinkel ab, der einen Teilbereich des Raumbereichs darstellt. Das Emitterelement sendet dementsprechend Laserlicht in diesen Raumwinkel aus. Die Emitterelemente decken gemeinsam den gesamten Raumbereich ab.

Die Empfangsoptik bildet ein Sensorelement auf einen Raumwinkel ab, der einen Teilbereich des Raumbereichs darstellt. Die Anzahl aller Sensorelemente deckt den gesamten Raumbereich ab. Emitterelemente und Sensorelemente, die denselben Raumwinkel betrachten bilden auf einander ab und sind dementsprechend einander zugewiesen. Ein Laserlicht eines Emitterelements bildet im Normalfall immer auf das zugehörige Sensorelement ab. Gegebenenfalls sind mehrere Sensorelemente innerhalb des Raumwinkels eines Emitterelements angeordnet.

Zur Ermittlung von Objekten innerhalb des Raumbereichs führt das Messsystem einen Messvorgang durch. Ein solcher Messvorgang umfasst einen oder mehrere Messzyklen, je nach konstruktivem Aufbau des Messsystems und dessen Elektronik.

Vorzugsweise wird das Time Correlated Single Photon Counting Verfahren, TCSPC, verwendet. Hierbei werden einzelne eintreffende Photonen detektiert, insbesondere durch SPAD, und der Zeitpunkt der Auslösung des Sensorelements, auch Detektionszeitpunkt, in einem Speicherelement abgelegt. Der Detektionszeitpunkt steht im Verhältnis zu einem Referenzzeitpunkt, zu dem das Laserlicht ausgesendet wird. Aus der Differenz lässt sich die Laufzeit des Laserlichts ermitteln, woraus der Abstand des Objekts bestimmt werden kann.

Ein Sensorelement kann einerseits von dem Laserlicht und andererseits von der Umgebungsstrahlung ausgelöst werden. Ein Laserlicht trifft bei einem bestimmten Abstand des Objekts immer zur gleichen Zeit ein, wohingegen die Umgebungsstrahlung jederzeit dieselbe Wahrscheinlichkeit bereitstellt ein Sensorelement auszulösen. Bei der mehrfachen Durchführung einer Messung, insbesondere mehrerer Messzyklen, summieren sich die Auslösungen des Sensorelements bei dem Detektionszeitpunkt, der der der Laufzeit des Laserlichts bezüglich der Entfernung des Objekts entspricht, wohingegen sich die Auslösungen durch die Umgebungsstrahlung gleichmäßig über die Messdauer eines Messzyklus verteilen. Eine Messung entspricht dem Aussenden und anschließendem Detektieren des Laserlichts. Die in dem Speicherelement abgelegten Daten der einzelnen Messzyklen eines Messvorgangs ermöglichen eine Auswertung der mehrfach ermittelten Detektionszeitpunkte, um auf den Abstand des Objekts zu schließen.

Ein Sensorelement ist günstigerweise mit einem Time to Digital Converter, TDC, verbunden, der den Zeitpunkt des Auslösens der Sensoreinheit in dem Speicherelement ablegt. Ein solches Speicherelement kann beispielsweise als Kurzzeitspeicher oder als Langzeitspeicher ausgebildet sein. Der TDC füllt für einen Messvorgang ein Speicherelement mit den Zeitpunkten, zu denen die Sensorelemente ein eintreffendes Photon detektierten. Dies lässt sich grafisch durch ein Histogramm, welches auf den Daten des Speicherelements basiert. Bei einem Histogramm ist die Dauer eines Messzyklus in kurze Zeitabschnitte unterteilt, sogenannte Bins. Wird ein Sensorelement ausgelöst, so erhöht der TDC den Wert eines Bin um eins. Es wird der Bin aufgefüllt, welcher der Laufzeit des Laserpulses entspricht, also die Differenz zwischen Detektionszeitpunkt und Referenzzeitpunkt.

Fig. 2 zeigt ein weiteres Ausführungsbeispiel eines Halbleiter-Package, das zumindest eine Vergussstruktur 60 umfasst. Das Halbleiter-Package 200 umfasst ein Package-Substrat 10, einen oberflächenemittierenden Laser 20, zwei Treiberschaltungen 30 für den oberflächenemittierenden Laser 20, eine Verbindungsstruktur 40 und zwei Interposer 50. Die Verbindungsstruktur umfasst eine Mehrzahl von Löthöckern. Der oberflächenemittierende Laser ist über den zumindest einen Interposer und die Verbindungsstruktur mit der zumindest einen Treiberschaltung elektrisch verschaltet. In vielerlei Hinsicht ist das Halbleiter-Package 200 somit ähnlich aufgebaut wie das Halbleiter-Package von Fig. 1.

Zusätzlich zum Halbleiter-Package von Fig. 1 umfasst das Halbleiter-Package 200 ferner die Vergussstruktur 60. Die Vergussstruktur ist aus einem Vergussmaterial ausgelegt, etwa aus einem Kunstharz. Dabei können beispielsweise thermoplastische oder duroplastische Kunststoffe verwendet werden. Die Vergussstruktur 60 ist dazu ausgelegt, um die Verbindungsstruktur 40 gegenüber Außeneinwirkungen abzuschirmen. So kann die Vergussstruktur 60 die Verbindungsstruktur 40, also die Mehrzahl von Löthöckern, zumindest dort vollständig umschließen, wo die Mehrzahl von Löthöckern nicht in Kontakt stehen mit Kontaktierungen des Interposers, der zumindest einen Treiberstruktur oder des oberflächenemittierenden Lasers. In dem Halbleiter-Package von Fig. 2 umschließt die Vergussstruktur 60 die zumindest eine Treiberschaltung 30 und die Verbindungsstruktur 40, sowie den oberflächenemittierenden Laser und den Interposer zumindest teilweise. Dabei ist darauf zu achten, dass der oberflächenemittierende Laser in einer Emissionsrichtung des oberflächenemittierenden Lasers nicht durch die Vergussstruktur verdeckt wird (es sei denn, ein transparentes Material wird für die Vergussstruktur verwendet).

Wie in Fig. 2 ferner gezeigt wird, kann die Vergussstruktur 60 ferner dazu ausgelegt sein, um die weitere Verbindungsstruktur (mit den Bond-Drähten 72) gegenüber Außeneinwirkungen abzuschirmen. In anderen Worten kann die Vergussstruktur 60 die weitere Verbindungsstruktur 40, also etwa die Bond-Drähte 72, zumindest dort vollständig umschließen, wo die weitere Verbindungsstruktur 40 nicht in Kontakt steht mit der Anschlussstruktur des Package-Substrats oder mit Kontakten des zumindest einen Treiberschaltung.

Mehr Details und Aspekte des Halbleiter-Package 200 werden in Verbindung mit dem Konzept oder Beispielen genannt, die vorher (z.B. Fig. 1) beschrieben wurden. Das Halbleiter-Package 200 kann ein oder mehrere zusätzliche optionale Merkmale umfassen, die ein oder mehreren Aspekten des vorgeschlagenen Konzepts oder der beschriebenen Beispiele entsprechen, wie sie vorher oder nachher beschrieben wurden.

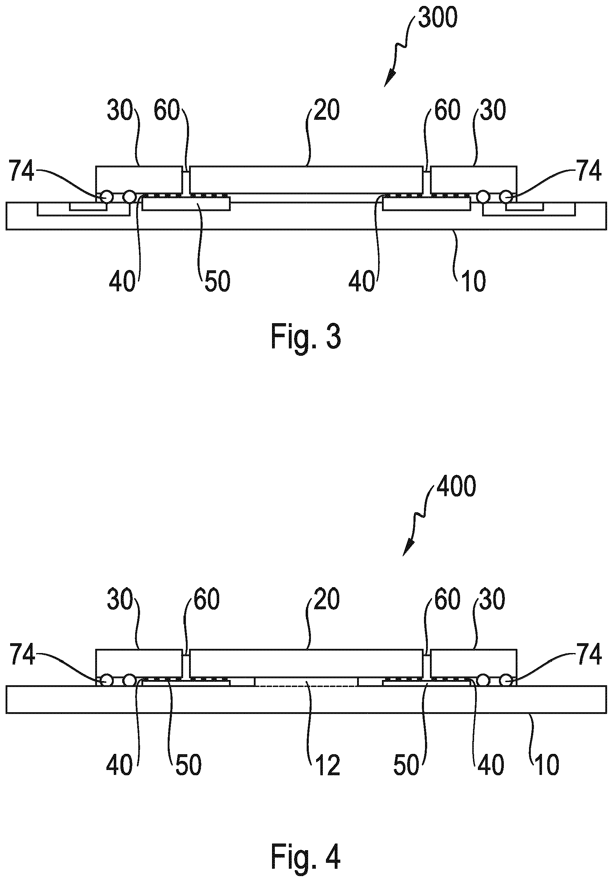

Fig. 3 zeigt ein weiteres Ausführungsbeispiel eines Halbleiter-Package, bei dem zwei Interposer 50 zwischen einem Package-Substrat 10 und einem oberflächenemittierenden Laser 20 angeordnet sind. Das Halbleiter-Package 300 umfasst das Package-Substrat 10, den oberflächenemittierenden Laser 20, zwei Treiberschaltungen 30 für den oberflächenemittierenden Laser 20, eine Verbindungsstruktur 40 und die zwei Interposer 50. Die Verbindungsstruktur umfasst eine Mehrzahl von Löthöckern. Der oberflächenemittierende Laser ist über die zwei Interposer und die Verbindungsstruktur mit der zumindest einen Treiberschaltung elektrisch verschaltet. In vielerlei Hinsicht ist das Halbleiter-Package 300 somit ähnlich aufgebaut wie die Halbleiter-Packages von Fig. 1 und/oder Fig. 2.

Im Gegensatz zu den Ausführungsbeispielen der Figuren 1 und 2 sind in dem Ausführungsbeispiel von Fig. 3 die beiden Interposer 50 vertikal zumindest teilweise zwischen dem oberflächenemittierenden Laser 20 und dem Package-Substrat 10 angeordnet. Ferner sind die beiden Interposer 50 vertikal zumindest teilweise zwischen einem der Interposer und dem Package-Substrat angeordnet. In einer weiteren denkbaren Ausführung können der oder die Interposer 50 in dem Package-Substrat 10 integriert sein, also etwa durch das Package-Substrat 10 gebildet werden, etwa falls das Package-Substrat aus Leiterplattenmaterial oder aus Halbleitermaterial gefertigt ist.

Entsprechend ist auch die Vergussstruktur 60 zumindest teilweise zwischen dem oberflächenemittierenden Laser 20 und dem Package-Substrat 10 angeordnet, und zumindest teilweise zwischen den beiden Treiberschaltungen und dem Package-Substrat. Dabei kann die Vergussstruktur als sog. Underfill (Unterfüllung) genutzt werden. Die Vergussstruktur kann ferner ausgebildet sein, um die weitere Verbindungsstruktur, hier gebildet durch Löthöcker 74, gegenüber äußeren Einflüssen abzuschirmen. Wie in Fig. 3 ferner zu sehen ist, ist die Vergussstruktur ferner zumindest teilweise lateral zwischen dem oberflächenemittierenden Laser und den beiden Treiberschaltungen angeordnet.

Wie bereits oben geschrieben umfasst das Halbleiter-Package 300 ferner die weitere Verbindungsstruktur. Eine Anschlussstruktur des Package-Substrats 10 (Kontaktpads, nicht gezeigt ist über die weitere Verbindungsstruktur mit der zumindest einen Treiberschaltung 30 elektrisch verschaltet. In diesem Fall umfasst die weitere Verbindungsstruktur ein über mehrere Löthöcker oder Lötkugeln 74, die zwischen den Treiberschaltungen und dem Package-Substrat angeordnet sind. In anderen Worten ist die zumindest eine Treiberschaltung 30 jeweils über ein oder mehrere Löthöcker 74 oder Lötkugeln der weiteren Verbindungsstruktur mit der Anschlussstruktur des Package-Substrats 10 elektrisch verschaltet. Zusätzlich umfasst die weitere Verbindungsstruktur Leiterbahnen, die die Löthöcker 74 mit den Kontaktierungen des Package-Substrats (nicht gezeigt), die zum Anschluss des Halbleiter-Package geeignet sind, elektrisch verschalten.

Mehr Details und Aspekte des Halbleiter-Package 300 werden in Verbindung mit dem Konzept oder Beispielen genannt, die vorher (z.B. Fig. 1 oder 2) beschrieben wurden. Das Halbleiter-Package 300 kann ein oder mehrere zusätzliche optionale Merkmale umfassen, die ein oder mehreren Aspekten des vorgeschlagenen Konzepts oder der beschriebenen Beispiele entsprechen, wie sie vorher oder nachher beschrieben wurden.

Fig. 4 zeigt ein weiteres Ausführungsbeispiel eines Halbleiter-Package 400, bei dem ein Teil des oberflächenemittierenden Lasers 20 in direktem Kontakt mit dem Package-Substrat 10 steht. Das Halbleiter-Package 400 umfasst das Package-Substrat 10, den oberflächenemittierenden Laser 20, zwei Treiberschaltungen 30 für den oberflächenemittierenden Laser 20, eine Verbindungsstruktur 40 und die zwei Interposer 50. Die Verbindungsstruktur umfasst eine Mehrzahl von Löthöckern. Der oberflächenemittierende Laser ist über die zwei Interposer und die Verbindungsstruktur mit der zumindest einen Treiberschaltung elektrisch verschaltet. In vielerlei Hinsicht ist das Halbleiter-Package 400 somit ähnlich aufgebaut wie eines der Halbleiter-Packages von Fig. 1 bis Fig. 3, insbesondere ähnlich wie das Halbleiter-Package von Fig. 3.

Wie auch in Fig. 3 ist der zumindest eine Interposer 50 zumindest teilweise vertikal zwischen dem oberflächenemittierenden Laser 20 und dem Package-Substrat 10 angeordnet und eine Vergussstruktur 60 zumindest teilweise zwischen dem oberflächenemittierenden Laser 20 und dem Package-Substrat 10 angeordnet. Im Gegensatz zu Fig. 3 steht zumindest ein Teil des oberflächenemittierenden Lasers 20 in direktem Kontakt mit dem Package-Substrat 10. Das Package-Substrat kann dabei einen Träger (engl. Submount) mit x-y-Stabilisator darstellen. Dafür kann das Package-Substrat einen Stabilisierungs-Abschnitt 12 abweisen, der in direktem Kontakt mit dem oberflächenemittierenden Laser 20 steht. Dieser Stabilisierung-Abschnitt ist eine gegenüber der restlichen Oberfläche des Package-Substrats erhöhter Abschnitt, der dafür vorgesehen ist, in direktem Kontakt mit dem oberflächenemittierenden Laser zu stehen. Dabei kann der Stabilisierungs-Abschnitt dazu ausgelegt sein, den oberflächenemittierenden Laser lateral zu stabilisieren, also ein Verrücken des oberflächenemittierenden Lasers in der lateralen Ebene zu verhindern.

Mehr Details und Aspekte des Halbleiter-Package 400 werden in Verbindung mit dem Konzept oder Beispielen genannt, die vorher (z.B. Fig. 1 bis 3) beschrieben wurden. Das Halbleiter-Package 400 kann ein oder mehrere zusätzliche optionale Merkmale umfassen, die ein oder mehreren Aspekten des vorgeschlagenen Konzepts oder der beschriebenen Beispiele entsprechen, wie sie vorher oder nachher beschrieben wurden.

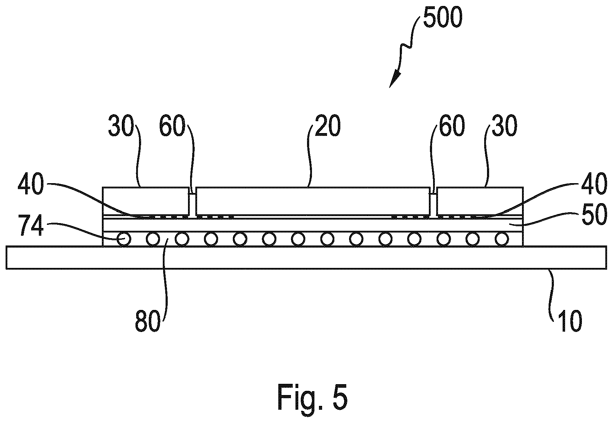

Fig. 5 zeigt ein weiteres Ausführungsbeispiel eines Halbleiter-Package 500, bei dem der oberflächenemittierende Laser 20 und zwei Treiberschaltungen 30 auf dem Interposer 50 angeordnet sind. Das Halbleiter-Package 500 umfasst das Package-Substrat 10, den oberflächenemittierenden Laser 20, zwei Treiberschaltungen 30 für den oberflächenemittierenden Laser 20, eine Verbindungsstruktur 40 und einen (einzigen) Interposer 50. Die Verbindungsstruktur umfasst eine Mehrzahl von Löthöckern. Der oberflächenemittierende Laser ist über den Interposer und die Verbindungsstruktur mit der zumindest einen Treiberschaltung elektrisch verschaltet. In vielerlei Hinsicht ist das Halbleiter-Package 400 somit ähnlich aufgebaut wie eines der Halbleiter-Packages von Fig. 1 bis Fig. 4.

Auch im Falle des Halbleiter-Package 500 ist der Interposer 50 vertikal zwischen dem oberflächenemittierenden Laser 20 und dem Package-Substrat 10 angeordnet. In diesem Fall bildet der Interposer sogar eine Plattform für den oberflächenemittierenden Laser 20 und die beiden Treiberschaltungen 30, d.h. in diesem Falle kann die Kombination aus Interposer, Laser, Treiberschaltungen und Verbindungsstruktur als zusammenhängende Einheit auf dem Package-Substrat 10 montiert werden. Dazu kann der Interposer 50 über die Verbindungsstruktur 40 kraftschlüssig mit dem oberflächenemittierenden Laser 20 und den Treiberschaltungen 30 gekoppelt sein. In diesem Fall sind der Interposer 50 und das Package-Substrat 10 zwei separate Bauteile. Alternativ kann der zumindest eine Interposer 50 durch das Package-Substrat 10 gebildet werden, oder vielmehr der Interposer 50 das Package-Substrat darstellen. In diesem Fall kann das Package-Substrat, das auch den Interposer 50 darstellt, ein Halbleiter-Bauelement sein. Wie auch in anderen Ausführungsbeispielen ist die Vergussstruktur 60 zumindest teilweise zwischen dem oberflächenemittierenden Laser 20 und/oder den Treiberschaltungen 30 und dem Package-Substrat 10 angeordnet.

Wie in Fig. 5 dargestellt ist kann das Halbleiter-Package 500 eine weitere Verbindungsstruktur umfassen. Eine Anschlussstruktur des Package-Substrats 10 kann über die weitere Verbindungsstruktur mit der zumindest einen Treiberschaltung 30 elektrisch verschaltet sein. Dies kann, wie in Fig. 5 gezeigt, durch Löthöcker oder Lötkugeln geschehen. In anderen Worten 11 kann die zumindest eine Treiberschaltung 30 jeweils über ein oder mehrere Löthöcker 74 der weiteren Verbindungsstruktur mit der Anschlussstruktur des Package-Substrats 10 elektrisch verschaltet sein. In diesem Fall kann die zumindest eine Treiberschaltung 30 jeweils über ein oder mehrere Löthöcker 74 der weiteren Verbindungsstruktur über den zumindest einen Interposer 50 mit der Anschlussstruktur des Package-Substrats elektrisch verschaltet sein. Alternativ können Bond-Drähte genutzt werden. In anderen Worten kann die zumindest eine Treiberschaltung 30 jeweils über ein oder mehrere Bond-Drähte der weiteren Verbindungsstruktur mit der Anschlussstruktur des Package-Substrats 10 elektrisch verschaltet sein. Dabei können die ein oder mehreren Bond-Drähte 72 mit der Anschlussstruktur des Package-Substrats 10 und mit Kontakten der Treiberschaltungen verbunden sein, etwa ähnlich wie in den Fign. 1 und 2. Alternativ könne die ein oder mehreren Bond-Drähte mit der Anschlussstruktur des Package-Substrats 10 und mit Kontakten des Interposers 50 verbunden sein (nicht gezeigt). Dazu kann eine horizontale Fläche des zumindest einen Interposers 50 eine horizontale Fläche des oberflächenemittierenden Lasers und der zumindest einen Treiberschaltung zumindest teilweise seitlich überragt, so dass ein Rand geschaffen wird, an dem die ein oder mehreren Bond-Drähte auf Kontakten des Interposers 50 befestigt werden können. In diesem Fall kann die weitere Verbindungsstruktur sowohl ein oder mehrere Löthöcker 74 (für die elektrische Verschaltung zwischen Treiberschaltung und Interposer) als auch ein oder mehrere Bond-Drähte (für die elektrische Verschaltung zwischen Interposer und Anschlussstruktur des Package-Substrats) umfassen. Die weitere Verbindungsstruktur kann dabei wiederum durch eine weitere Vergussstruktur 80 abgeschirmt werden.

Mehr Details und Aspekte des Halbleiter-Package 500 werden in Verbindung mit dem Konzept oder Beispielen genannt, die vorher (z.B. Fig. 1 bis 4) beschrieben wurden. Das Halbleiter-Package 500 kann ein oder mehrere zusätzliche optionale Merkmale umfassen, die ein oder mehreren Aspekten des vorgeschlagenen Konzepts oder der beschriebenen Beispiele entsprechen, wie sie vorher oder nachher beschrieben wurden.

### Bezugszeichen

- 10: Package-Substrat
- 12: Stabilisierungs-Abschnitt
- 20: Oberflächenemittierender Laser
- 30: Treiberschaltung
- 40: Verbindungsstruktur
- 50: Interposer
- 60: Vergussstruktur
- 72: Bond-Drähte
- 74: Löthöcker
- 80: Weitere Vergussstruktur
- 100, 200, 300, 400, 500: Halbleiter-Package

## Patentansprüche

1. Ein Halbleiter-Package (100; 200; 300; 400; 500) umfassend:
einen oberflächenemittierenden Laser (20);
zumindest eine Treiberschaltung (30) für den oberflächenemittierenden Laser (20);
eine Verbindungsstruktur (40), wobei die Verbindungsstruktur eine Mehrzahl von Löthöckern umfasst; und
zumindest einen Interposer (50), wobei der oberflächenemittierende Laser über den zumindest einen Interposer und die Verbindungsstruktur mit der zumindest einen Treiberschaltung elektrisch verschaltet ist.

2. Das Halbleiter-Package gemäß Anspruch 1, ferner umfassend eine Vergussstruktur (60), wobei die Vergussstruktur (60) dazu ausgelegt ist, um die Verbindungsstruktur (40) gegenüber Außeneinwirkungen abzuschirmen.

3. Das Halbleiter-Package gemäß Anspruch 2, wobei die Vergussstruktur (60) zumindest teilweise zwischen dem oberflächenemittierenden Laser (20) und einem Package-Substrat (10) des Halbleiter-Package angeordnet ist.

4. Das Halbleiter-Package gemäß Anspruch 3, wobei zumindest ein Teil des oberflächenemittierenden Lasers (20) in direktem Kontakt mit dem Package-Substrat (10) steht.

5. Das Halbleiter-Package gemäß einem der vorherigen Ansprüche, wobei der zumindest eine Interposer (50) zumindest teilweise vertikal zwischen dem oberflächenemittierenden Laser (20) und einem Package-Substrat (10) des Halbleiter-Package angeordnet ist, oder wobei der zumindest eine Interposer (50) durch das Package-Substrat (10) gebildet wird.

6. Das Halbleiter-Package gemäß einem der vorherigen Ansprüche, wobei der zumindest eine oberflächenemittierende Laser (20) zumindest teilweise vertikal zwischen dem zumindest einen Interposer (50) und einem Package-Substrat (10) des Halbleiter-Package angeordnet ist.

7. Das Halbleiter-Package gemäß einem der vorherigen Ansprüche, wobei die Mehrzahl von Löthöckern einer Mehrzahl von Mikro-Höckern entspricht.

8. Das Halbleiter-Package gemäß einem der vorherigen Ansprüche, umfassend eine weitere Verbindungsstruktur, wobei eine Anschlussstruktur eines Package-Substrats (10) des Halbleiter-Package über die weitere Verbindungsstruktur mit der zumindest einen Treiberschaltung (30) elektrisch verschaltet ist.

9. Das Halbleiter-Package gemäß Anspruch 8, ferner umfassend eine weitere Vergussstruktur (80), wobei die weitere Vergussstruktur dazu ausgelegt ist, um die weitere Verbindungsstruktur gegenüber Außeneinwirkungen abzuschirmen.

10. Das Halbleiter-Package gemäß einem der Ansprüche 8 oder 9, wobei die zumindest eine Treiberschaltung (30) jeweils über ein oder mehrere Bond-Drähte (72) der weiteren Verbindungsstruktur mit der Anschlussstruktur des Package-Substrats (10) elektrisch verschaltet ist.

11. Das Halbleiter-Package gemäß einem der Ansprüche 8 bis 10, wobei die zumindest eine Treiberschaltung (30) jeweils über ein oder mehrere Löthöcker (74) der weiteren Verbindungsstruktur mit der Anschlussstruktur des Package-Substrats (10) elektrisch verschaltet ist.

12. Das Halbleiter-Package gemäß Anspruch 11, wobei die zumindest eine Treiberschaltung (30) jeweils über ein oder mehrere Löthöcker (74) der weiteren Verbindungsstruktur (70) über den zumindest einen Interposer (50) mit der Anschlussstruktur des Package-Substrats (10) elektrisch verschaltet ist.

13. Das Halbleiter-Package gemäß einem der vorherigen Ansprüche, wobei der zumindest eine Interposer (50) zumindest ein Halbleiter-Bauelement ist.

14. Das Halbleiter-Package gemäß einem der vorherigen Ansprüche, wobei eine horizontale Fläche des zumindest einen Interposers (50) eine horizontale Fläche des oberflächenemittierenden Lasers und der zumindest einen Treiberschaltung zumindest teilweise seitlich überragt.

15. LIDAR-Sendeeinheit umfassend das Halbleiter-Package (100; 200; 300; 400; 500) gemäß einem der vorherigen Ansprüche.
